Europäisches Patentamt

European Patent Office

Office européen des brevets

(11) Veröffentlichungsnummer: **0 400 177**
**A1**

## (12) EUROPÄISCHE PATENTANMELDUNG

(21) Anmeldenummer: **89109836.0**

(22) Anmeldetag: **31.05.89**

(51) Int. Cl.⁵: **H01L 23/492**

(43) Veröffentlichungstag der Anmeldung:
**05.12.90 Patentblatt 90/49**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Hainz, Oswald**
**Buchenweg 11**
**D-8412 Burglengenfeld(DE)**
Erfinder: **Zuhr, Bernd**
**Allgäustrasse 73**
**D-8000 München 71(DE)**

(54) Verbindung eines Halbleiterbauelements mit einem Metallträger.

(57) Eine Verbindung eines Halbleiterbauelements (1) mit einem Metallträger (2) soll zuverlässig sein. Zwischen dem Halbleiterbauelement (1) und dem Metallträger (2) ist ein Pufferwerkstoff (14) angebracht. Der Metallträger (2) weist Versteifungen auf. Eine Schwächung des Metallträgers (2) dient zur Erhöhung der Flexibilität des Metallträgers (2).

FIG 8

EP 0 400 177 A1

## Verbindung eines Halbleiterbauelements mit einem Metallträger

Die Erfindung betrifft eine Verbindung eines Halbleiter-Bauelements mit einem Metallträger.

In der elektronischen Industrie werden in steigendem Umfang Bauelemente auf der Basis der Festkörpertechnik hergestellt. Bei zahlreichen Bauelementetypen ist zur Sicherung der Funktionsfähigkeit das Bonden (Die-Bonden) eines Silizium-Chips auf einem Träger aus Kupfer oder aus einem anderen Metall wie beispielsweise Stahl erforderlich. Die auftretenden inneren Spannungen bei einer Bond-Temperatur von etwa 370° C führen sehr oft zu einer Zerstörung der Verbindung und können die elektrischen Eigenschaften des Halbleiterbauelements verändern, z. B. kann eine Überlastung in Folge verschlechteter Wärmeleitung auftreten.

Eine Veröffentlichung über "Deformationen und innere Spannungen beim Bonden von Festkörperschaltkreisen" ist in der Zeitschrift "Feingerätetechnik", 25. Jahrgang, Heft 5, 1976, Seiten 198-200 erschienen.

Durch unterschiedliche Längenausdehnungskoeffizienten von Halbleiterbauelement und Metallträger können beim Abkühlen der Verbindung von der Legiertemperatur auf Raumtemperatur so große Spannungen auftreten, daß das Halbleiterbauelement abplatzt und/oder daß im Halbleiterbauelement Anrisse entstehen. Je größer der Biegeradius des Halbleiterbauelements beim Abkühlen wird, mit desto größerer Wahrscheinlichkeit wird das Halbleiterbauelement zerstört bzw. beschädigt.

Der vorliegenden Erfindung liegt die Aufgabe zugrunde, eine Verbindung der eingangs genannten Art anzugeben, mit der eine zuverlässige Verbindung zwischen Halbleiterbauelement und Metallträger erzielt werden kann.

Diese Aufgabe wird erfindungsgemäß durch eine Verbindung nach Anspruch 1 und/oder Anspruch 6 und/oder Anspruch 10 gelöst.

Eine Kombination von verschiedenen Maßnahmen nach unterschiedlichen Patentansprüchen ist ohne weiteres möglich.

Ausgestaltungen und Vorteile der Erfindung sind in Unteransprüchen, der Beschreibung und der Zeichnung angegeben.

Besonders vorteilhaft läßt sich die vorliegende Erfindung verwenden zur Verwirklichung einer zuverlässigen Halbleiter-Chip-Verbindung durch eutektisches Legieren eines Silizium-Chips auf einem Kupfer-Träger-Band unter Verwendung einer Goldschicht auf der Rückseite des Halbleiter-Bauelements.

Besonders vorteilhaft ist die vorliegende Erfindung für die Herstellung von oberflächenmontierbaren (SMD) Bauelementen.

Besonders vorteilhaft ist die Anwendung der vorliegenden Erfindung bei Metallträgern, die relativ dünn sind (dünner als 250 $\mu$m, insbesondere dünner als 150 $\mu$m). Daher ist die vorliegende Erfindung besonders vorteilhaft für die Herstellung von SOT 23-Bauelementen.

Die Erfindung ermöglicht die Verwendung von dünneren und/oder preiswerteren Metallträgern. Bei der Herstellung von Halbleiterbauelementen in lead-frame-Technik ist ein hoher Anteil der Kosten auf die Kosten des lead-frames (metallischer Träger) zurückzuführen.

Besonders vorteilhaft ist die Erfindung für das Direkt-Bonden eines Silizium-Halbleiterbauelements auf einen Kupferträger mit Hilfe eines Gold-Silizium-Eutektikums zwischen dem Halbleiterbauelement und dem Kupferträger.

Besonders vorteilhaft ist die Verwendung einer dicken Goldschicht (2-5 $\mu$m, insbesondere 3,5 $\mu$m dick) als Pufferwerkstoff zwischen Halbleiterbauelement und Metallträger. Als Pufferwerkstoff kann weiches Material verwendet werden, das kriechen kann und Spannungen abbauen kann. Beim Die-Bonden wird Lot zwischen dem Halbleiter-Bauelement und dem Metallträger ausgepreßt. Durch eine Profilierung des Metallträgers wird erreicht, daß das Lot zwischen Halbleiterbauelement und Metallträger zurückgehalten wird.

Eine partielle Verdickung des Metallträgers ist vorteilhaft für die Erfindung.

Beim Abkühlen von der Lottemperatur auf Raumtemperatur entstehen sowohl eine Biegebeanspruchung als auch eine Zugbeanspruchung. Durch partielle Versteifungen des Metallträgers und/oder mit Hilfe eines Pufferwerkstoffs zwischen Halbleiterbauelement und Metallträger können Spannungen abgebaut werden.

Ein Pufferwerkstoff soll so dick aufgebracht sein, daß er zum Abbau von Spannungen beitragen kann. Ein Pufferwerkstoff soll jedoch nicht allzu dick sein, um überhöhte zusätzliche Kosten zu vermeiden. Bei Verwendung einer dickeren Schicht als Pufferwerkstoff kann das Herauslaufen des Pufferwerkstoffs aus dem Bereich zwischen Halbleiterbauelement und Metallträger durch eine Vielfalt von verschiedenen Maßnahmen verhindert werden. Zu diesem Zweck kann an der Rückseite des Halbleiterbauelements und/oder an der Vorderseite des Metallträgers, auf welche das Halbleiterbauelement aufzubringen ist, eine Struktur vorhanden sein, die eine Fixierung einer ausreichenden Lotmenge zwischen Halbleiterbauelement und Metallträger erlaubt. Eine solche Oberflächenstruktur kann Riefen und/oder Rillen und/oder Nuten und/oder wenigstens eine Kavität und/oder eine sonstige Rauhigkeit aufweisen. Eine solche Oberflächenstruktur kann durch Prägung oder durch Formung oder durch Aufrauhen erzielt werden. Die Tiefe der Oberflächenstruktur kann zwischen einem und 10 μm, insbesondere zwischen 2 und 5 μm betragen.

Partielle Versteifungen des Metallträgers können durch Profile oder durch Wulste oder durch Verdickungen erzeugt werden.

Die Zuverlässigkeit der Verbindung zwischen einem Halbleiterbauelement und einem Metallträger kann auch dadurch erhöht werden, daß die Flexibilität des Metallträgers durch Schwächung des Metallträgers erhöht wird. Beispielsweise kann der Metallträger so stark eingeprägt werden, daß er sich biegen kann.

Die Erfindung wird anhand der Zeichnung näher erläutert.

FIG 1 bis 3 erläutern das zugrunde liegende Problem. FIG 4 bis 9 erläutern verschiedene Maßnahmen gemäß der Erfindung.

FIG 10 bis 19 zeigen Ausführungsbeispiele von Metallträgern.

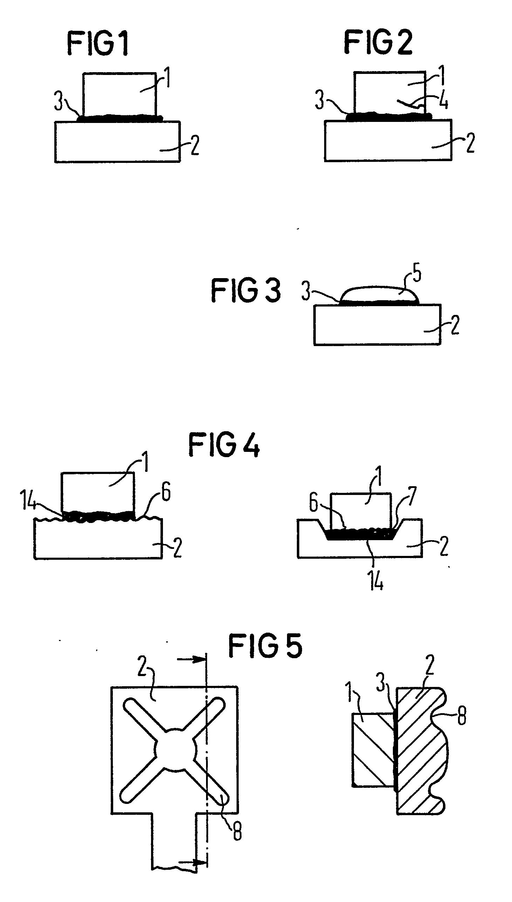

FIG 1 zeigt die Verbindung eines Halbleiterbauelements 1 mit einem Metallträger 2 mit einer Gold-Rückseite 3 des Halbleiterbauelements 1. Beispielsweise wird ein Silizium-Chip 1 mit Hilfe eines Gold-Silizium-Eutektikums bei einer Bond-Temperatur von etwa 370° C auf ein Kupfer-Band 2 gebondet (Die-Bonden).

Durch unterschiedliche Längenausdehnungskoeffizienten von Silizium und Kupfer können beim Abkühlen der Verbindung von der Legiertemperatur auf Raumtemperatur so große Spannungen auftreten, daß im Silizium-Bauelement Anrisse 4 entstehen (FIG 2) bzw. daß der Silizium-Chip abplatzt. Nach dem Abplatzen des Silizium-Chips verbleibt auf dem Metallträger 2 nur noch ein Silizium-Rest 5 (FIG 3).

FIG 4 zeigt die Verwendung eines Pufferwerkstoffs 14 zwischen Halbleiterbauelement 1 und Metallträger 2. Als Pufferwerkstoff 14 kann jedes weiche Material verwendet werden, das geeignet ist, Spannungen abzubauen. Beispielsweise kann als Pufferwerkstoff 14 eine 3 μm dicke Gold-Rückseite auf dem Halbleiterbauelement 1 dienen. Durch Erzeugen einer Rauhigkeit 6 auf dem Metallträger von ca. 2 bis 5 μm Tiefe kann das Herauslaufen des Pufferwerkstoffs 14 aus dem Bereich zwischen Halbleiterbauelement 1 und Metallträger 2 beim Die-Bonden vermieden werden. Die Rauhigkeit 6 kann z. B. durch Prägen erzeugt werden. Das Heraus laufen des Pufferwerkstoffs 14 kann auch noch durch Verwendung einer Kavität 7 auf der Rückseite des Halbleiterbauelements 1 und/oder auf der Vorderseite des Metallträgers 2 verhindert werden. Eine Rauhigkeit 6 kann auch auf der Rückseite des Halbleiterbauelements 1 aufgebracht sein.

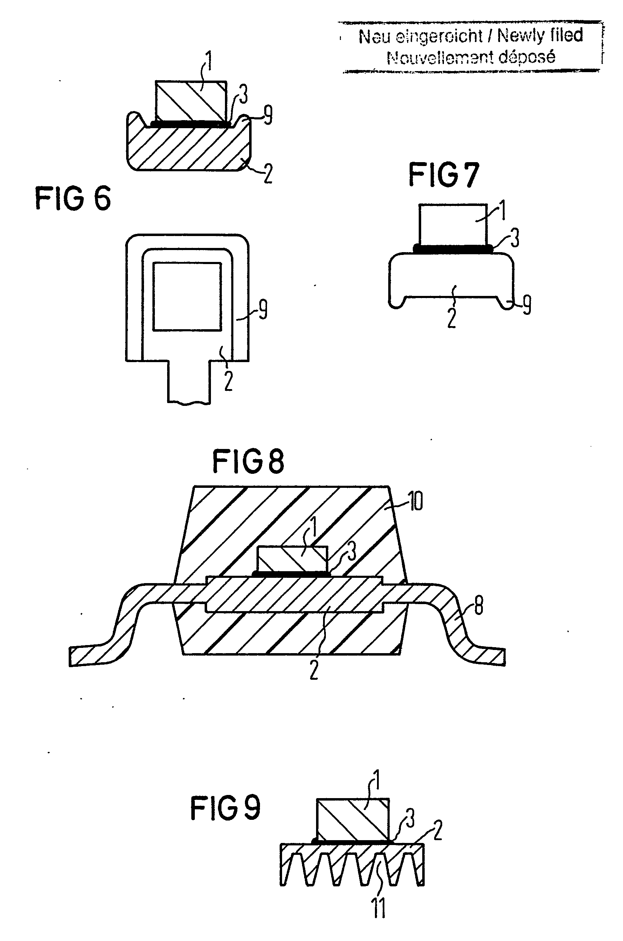

FIG 5 bis 8 erläutern eine Erhöhung der Steifigkeit des Metallträgers 2 durch Versteifungen. In FIG 5 wird die Steifigkeit des Metallträgers 2 durch geprägte Sicken 8 erzielt. In FIG 6 und in FIG 7 wird eine Erhöhung der Bandsteifigkeit durch eine Profilierung 9 des Metallträgers 2 erzielt. Dabei ist in FIG 6 das Halbleiterbauelement 1 mit der profilierten Seite des Metallträgers 2 und in FIG 7 mit der der profilierten Seite des Metallträgers 2 entgegengesetzten Seite verbunden.

FIG 8 zeigt einen Metallträger 2, der im Bereich der Verbindung zwischen dem Halbleiterbauelement 1 und dem Metallträger 2 partiell durch Geometrieänderung verdickt ist. Beispielsweise kann ein Kupfer-Band, das sonst eine Dicke von 100 oder 125 μm aufweist (SOT 23), im Bereich der Verbindung mit dem Halbleiterbauelement 1 auf eine Dicke von 200 μm verdickt sein. Das oberflächenmontierbare Bauelement nach FIG 8 besitzt eine Umhüllung 10.

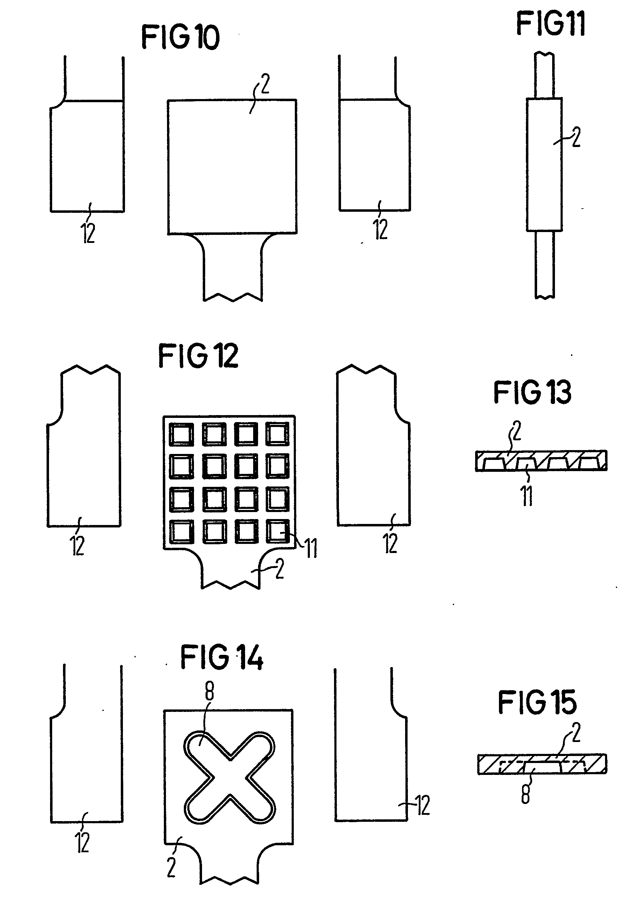

FIG 9 erläutert die Erhöhung der Flexibilität des Metallträgers 2 durch Schwächung des Metallträgers 2. Dabei sind im Metallträger 2 Prägungen angebracht. Wenn der Metallträger 2 eine übliche Dicke von 100 oder 125 μm besitzt, kann er innerhalb der Prägungen 11 eine Restdicke von beispielsweise 20 bis 50 μm besitzen. Auch andere Restdicken sind möglich, insbesondere in Verbindung mit anderen Maßnahmen im Rahmen dieser Erfindung.

FIG 10 zeigt einen Metallträger 2 bei einem SOT 23-Band, der im Bereich der Verbindung mit einem Halbleiterbauelement 1 eine Dicke von etwa 250 μm aufweist, während das Metallband im übrigen Bereich eine Dicke von 125 μm aufweist. Mit dieser partiellen Versteifung kann die Biegebeanspruchung zwischen Halbleiterbauelement 1 und Metallträger 2 beseitigt werden. Die Biegebeanspruchung kann auch durch eine Kombination von Versteifung des Metallträgers 2 und Pufferwerkstoff 14 zwischen Halbleiterbauelement 1 und Metallträger 2 beseitigt werden. Das lead-frame besitzt außer dem Metallträger 2 auch noch Bond-Flächen 12 für die elektrische Verbindung mit dem Halbleiterbauelement 1 mit Hilfe von Bonddrähten.

FIG 12 und 13 zeigen einen Metallträger 2, bei dem zur Erhöhung der Bandflexibilität schachbrettartig Vertiefungen 11 angebracht sind. Wenn der Metallträger 2 eine Dicke von 125 μm aufweist, so besitzt der Metallträger 2 im Bereich der Vertiefungen nur noch eine Restdicke von 45 μm. Die Prägungen sind vorteilhafterweise in Pyramidenform ausgeführt.

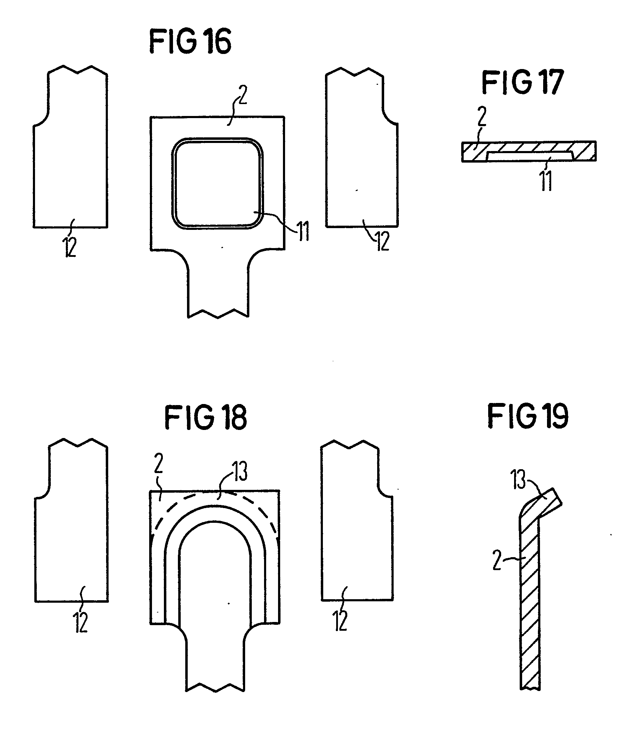

FIG 14 und 15 zeigen einen Metallträger 2 mit Sicken 8. Im Bereich der Sicken 8 besitzt der Metallträger 2 Vertiefungen.

Die FIG 16 und 17 zeigen einen Metallträger, bei dem die Vertiefung 11 so ausgeführt ist, daß ein profilierter Metallträger 2 entstanden ist. Während bei den FIG 12 und 14 die Vertiefungen 8 bzw. 11 auf der Rückseite des Metallträgers 2 angebracht sind, sind bei den FIG 16 und 18 die Vertiefungen auf der Vorderseite des Metallträgers 2 erzeugt. In FIG 16 wird also das Halbleiterbauelement 1 in der Vertiefung 11 gebondet.

FIG 18 und 19 zeigen einen Metallträger 2 mit einem Wulst 13. Sämtliche Vertiefungen bzw. Wulste bei den FIG 12 bis 19 können durch Prägung erzielt werden.

Eine zuverlässige Verbindung zwischen Halbleiterbauelement 1 und Metallträger 2 kann durch Verwendung eines Pufferwerkstoffes, durch partielle Versteifung des Metallträgers, durch Erhöhung der Flexibiliät des Metallträgers durch Schwächung des Metallträgers und durch eine beliebige Kombination dieser Maßnahmen erzielt werden.

## Ansprüche

1. Verbindung eines Halbleiterbauelements (1) mit einem Metall-Träger (2), mit einem Pufferwerkstoff (14) zwischen Halbleiterbauelement (1) und Metallträger (2), mit einer Struktur der an den Pufferwerkstoff (14) angrenzenden Oberfläche von Halbleiterbauelement (1) und/oder Metallträger (2) zur Fixierung des Pufferwerkstoffs (14).

2 Verbindung nach Anspruch 1,
**dadurch gekennzeichnet,** daß die Struktur der Oberfläche eine Tiefe zwischen 1 und 10 $\mu$m besitzt.

3. Verbindung nach Anspruch 2,
**dadurch gekennzeichnet,** daß die Struktur der Oberfläche eine Tiefe zwischen 2 und 5 $\mu$m besitzt.

4. Verbindung nach einem der Ansprüche 1 bis 3,
**gekennzeichnet durch,** Gold als Pufferwerkstoff (14).

5. Verbindung nach Anspruch 4,
**gekennzeichnet durch** eine Goldschicht als Pufferwerkstoff (14) mit einer Dicke zwischen 2 und 5 $\mu$m.

6. Verbindung eines Halbleiterbauelements (1) mit einem Metallträger (2),
**gekennzeichnet durch** Versteifungen des Metallträgers (2).

7. Verbindung nach Anspruch 6,
**gekennzeichnet durch** wenigstens eine Sicke (8).

8. Verbindung nach Anspruch 6 oder 7, **gekennzeichnet durch** wenigstens eine Profilierung (9).

9. Verbindung nach einem der Ansprüche 6 bis 8,
**gekennzeichnet durch** Geometrieänderung des Metallträgers (2).

10. Verbindung eines Halbleiterbauelements (1) mit einem Metallträger (2),
**gekennzeichnet durch** Schwächung des Metallträgers (2) zur Erhöhung der Flexibilität des Metallträgers (2).

FIG 1

FIG 2

FIG 3

FIG 4

FIG 5

**FIG 6**

**FIG 7**

**FIG 8**

**FIG 9**

**FIG 10**

**FIG 11**

**FIG 12**

**FIG 13**

**FIG 14**

**FIG 15**

**FIG 16**

**FIG 17**

**FIG 18**

**FIG 19**

Europäisches Patentamt

**EUROPÄISCHER RECHERCHENBERICHT**

Nummer der Anmeldung

EP 89 10 9836

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-A-2 704 405 (DEMETRON) <br> * Ansprüche 1,4 * | 1 | H 01 L 23/492 |
| A | | 2-5 | |
| | --- | | |
| Y | FR-A-2 469 018 (THOMSON) <br> * Anspruch 6 * | 1 | |
| A | | 9 | |
| | --- | | |
| Y | DE-A-3 110 080 (SIEMENS) <br> * Ansprüche 1,8 * | 1 | |
| A | | 5 | |
| | --- | | |
| A | PATENT ABSTRACTS OF JAPAN, Band 6, Nr. 136 (E-120)[1014], 23. Juli 1982; & JP-A-57 60 860 (NIPPON DENKI K.K.) 13-04-1982 | 1,8-10 | |
| | --- | | |
| A | FR-A-1 485 421 (DUVERNOIS) <br> * Figur 2 * | 8 | |
| | --- | | |
| A | DE-A-2 557 371 (GENERAL ELECTRIC) <br> * Figur 14 * | 6 | **RECHERCHIERTE SACHGEBIETE (Int. Cl.5)** |
| | --- | | |
| A | FR-A-2 132 846 (AMP) <br> * Figur 2; Anspruch 1 * | 6,9 | H 01 L |
| | ----- | | |

Der vorliegende Recherchenbericht wurde für alle Patentansprüche erstellt

| Recherchenort | Abschlußdatum der Recherche | Prüfer |
|---|---|---|
| DEN HAAG | 22-12-1989 | DE RAEVE R.A.L. |